# EUROPÄISCHE PATENTANMELDUNG

(11) **EP 1 126 696 A2**
(43) Veröffentlichungstag der Anmeldung: **22.08.2001**
(21) Anmeldenummer: 01200147.5
(22) Anmeldetag: 16.01.2001
(51) Int. Cl.: H04N 5/21

(54) **Anordnung zur Filterung digitaler Daten**

(30) Priorität: 25.01.2000 DE 10002964
(71) Anmelder: Philips Corporate Intellectual Property GmbH, 52064 Aachen (DE); Koninklijke Philips Electronics N.V., 5621 BA Eindhoven (NL)
(72) Erfinder: Berg, Michael, Philips Corporate Int. Prop. GmbH, 52064 Aachen (DE); Gehrke, Winfried, Dr., 52064 Aachen (DE)
(74) Vertreter: Volmer, Georg, Dipl.-Ing.

(57) **Zusammenfassung**

Bei einer Filter-Anordnung zur Filterung digitaler Daten, welche Synchronisationsinformationen enthalten, wobei die Anordnung in einem Systemtakt arbeitet, ist zur geordneten Datenübernahme zur schnellstmöglichen Aufsynchronisation nach einer Störung der Daten vorgesehen,
dass die Anordnung ein erstes (1) und einem diesem nachgeschaltetes zweites Filter (2), dass das Ausgangssignal der Anordnung liefert, aufweist,
dass dem ersten Filter (1) wenigstens die in den Daten enthaltenen Synchronisationsinformationen und dem zweiten Filter (2) das Ausgangssignal des ersten Filters (1) sowie die digitalen Daten zugeführt werden,
dass das erste Filter (1) in einem sich zyklisch wiederholenden Vorgang eine Synchronisationsinformation sucht, diese an seinen Ausgang durchschaltet, nachfolgend während einer vorgegebenen Anzahl von Systemtaktimpulsen alle ggf. auftretenden Synchronisationsinformationen sperrt und nach Ablauf der vorgegebenen Anzahl von Systemtakten wieder die nächste Synchronisationsinformation sucht und durchschaltet, und dass das zweite Filter (2) in einem sich zyklisch wiederholenden Vorgang ab einer von dem ersten Filter (1) gelieferten Synchronisationsinformation eine vorgegebene Anzahl von Daten aus dem Datensignal übernimmt und an seinen Ausgang durchschaltet und nachfolgende Daten bis zur nächsten von dem ersten Filter (1) gelieferten Synchronisationsinformation sperrt, ab der wieder die vorgegebene Anzahl von Daten dem Datensignal übernommen und an den Ausgang durchgeschaltet werden.

## Beschreibung

Die Erfindung betrifft eine Filter-Anordnung zur Filterung digitaler Daten, welche Synchronisationsinformationen enthalten, wobei die Anordnung in einem Systemtakt arbeitet.

Liegen digitale Daten in einem ersten Takt vor und sollen diese Daten von einem Gerät in einem zweiten Takt weiter verarbeitet werden und wird weiter davon ausgegangen, dass die beiden Takte nicht miteinander verkoppelt sind, so entsteht an der Schnittstelle zwischen den Schaltungselementen, die mit dem ersten bzw. dem zweiten Takt arbeiten, das Problem, dass die Übernahme der Daten gegebenenfalls nicht vollständig gelingt, dass also nicht alle Daten übernommen werden. Ebenso kann das Problem entstehen, dass Daten doppelt übernommen werden.

Sind, beispielsweise bei Videodaten, in derartigen Daten Synchronisationsinformationen enthalten, so sollen die Daten darüber hinaus geordnet nach den Synchronisationsinformationen übernommen werden, da sie nur so weiter weiterverarbeitet werden können. Bei Videodaten ist es wichtig, die Daten teilbildweise und/oder bildzeilenweise geordnet in dem zweiten Takt zu übernehmen. Außerdem besteht das Problem, dass durch Synchronisationssignale gekennzeichnete Dateneinheiten/pakete, bei Videodaten beispielsweise Videohalb- oder Vollbilder, möglicherweise von dem ersten Takt schneller geliefert werden als sie im zweiten Takt verarbeitet werden können. Dann müssen Teile der Videodaten bzw. ganze Blöcke fallengelassen werden.

Es ist Aufgabe der Erfindung, eine Anordnung zur Filterung derartiger Daten zu schaffen, welche die oben erläuterten Probleme überwindet und darüber hinaus in der Lage ist, nach Datenstörstellen, in denen die Daten nicht in der gewünschten Reihenfolge auftreten, diese nachfolgend dennoch wieder geordnet nach den Synchronisationsinformationen zur Verfügung zu stellen.
Diese Aufgabe ist erfindungsgemäß dadurch gelöst, dass die Anordnung ein erstes und einem diesem nachgeschaltetes zweites Filter, das das Ausgangssignal der Anordnung liefert, aufweist,
dass dem ersten Filter wenigstens die in den Daten enthaltenen Synchronisationsinformationen und dem zweiten Filter das Ausgangssignal des ersten Filters sowie die digitalen Daten zugeführt werden,
dass das erste Filter in einem sich zyklisch wiederholenden Vorgang eine Synchronisationsinformation sucht, diese an seinen Ausgang durchschaltet, nachfolgend während einer vorgegebenen Anzahl von Systemtaktimpulsen alle ggf. auftretenden Synchronisationsinformationen sperrt und nach Ablauf der vorgegebenen Anzahl von Systemtakten wieder die nächste Synchronisationsinformation sucht und durchschaltet, und dass das zweite Filter in einem sich zyklisch wiederholenden Vorgang ab einer von dem ersten Filter gelieferten Synchronisationsinformation eine vorgegebene Anzahl von Daten aus dem Datensignal übernimmt und an seinen Ausgang durchschaltet und nachfolgende Daten bis zur nächsten von dem ersten Filter gelieferten Synchronisationsinformation sperrt, ab der wieder die vorgegebene Anzahl von Daten dem Datensignal übernommen und an den Ausgang durchgeschaltet werden.

Die Anordnung weist also zwei Filter auf, die beide im Systemtakt arbeiten. Dem ersten Filter werden die in den Daten enthaltenen Synchronisationsinformationen zugeführt. Dem zweiten Filter wird einerseits das Ausgangssignal des ersten Filters, also die gefilterten Synchronisationsinformationen, und andererseits die digitalen Daten zugeführt.

Das erste Filter arbeitet in einem sich zyklisch wiederholenden Vorgang. Dabei wird nach Übernahme einer Synchronisationsinformation aus dem dem Filter zugeführten Eingangssignal nachfolgend während einer vorgegebenen Anzahl von Systemtaktimpulsen keine neue Synchronisationsinformation mehr übernommen. Das heißt das Filter sperrt und schaltet in dieser Zeitspanne gegebenenfalls in dem Eingangssignal auftretende Synchronisationsinformationen nicht an seinen Ausgang weiter. Erst nach Ablauf der vorgegebenen Anzahl von Systemtaktimpulsen wird die nächstfolgende Synchronisationsinformation wieder übernommen, d.h. an den Ausgang des Filters weitergeschaltet. Nun wiederholt sich der Vorgang, so dass wiederum während der vorgegebenen Anzahl von Systemtaktimpulsen das erste Filter sperrt, d.h. gegebenenfalls auftretende Synchronisationsinformationen nicht an seinen Ausgang weiterschaltet. Erst nach Ablauf dieser Zeitspanne wird wieder der nächste Synchronisationsimpuls übernommen. Dieser Vorgang wiederholt sich zyklisch.

Im Ergebnis wird damit erreicht, dass das erste Filter Synchronisationsimpulse nur dann durchläßt, wenn sie einen Mindestzeitabstand voneinander aufweisen. Damit wird erreicht, dass dann, wenn der Datenfluß zu groß ist, nur solche Synchronisationsinformationen übernommen werden, die dieser Mindestbedingung entsprechen.

Das zweite Filter arbeitet ebenfalls in einem sich zyklisch wiederholenden Ablauf. Wird von dem ersten Filter eine Synchronisationsinformation an das zweite Filter geliefert, so übernimmt dieses nachfolgend eine vorgegebene Anzahl von Daten aus dem Datensignal. Hier findet also keine Orientierung an der Anzahl von Systemtaktimpulsen statt, vielmehr orientiert sich das zweite Filter an der Anzahl von Daten. Hat das zweite Filter die vorgegebene Anzahl von Daten nach einer Synchronisationsinformation übernommen, so sperrt das Filter nachfolgend, d.h. es leitet keine weiteren Daten an seinen Ausgang weiter. Erst wenn das erste Filter die nächste Synchronisationsinformation liefert, übernimmt das zweite Filter nachfolgend wieder die vorgegebene Anzahl von Daten aus dem Datensignal und sperrt nachfolgend wieder bis zum Auftreten der nächsten vom ersten Filter gelieferten Synchronisationsinformation.

Damit wird erreicht, dass jedes Datenpaket vervollständigt wird, bevor ein neues begonnen wird. Überschüssige Daten werden fallengelassen. Somit steht am Ausgang des zweiten Filters immer ein Datenformat der gewünschten Form zur Verfügung. Das Datenformat sieht dabei so aus, dass einer Synchronisationsinformation immer eine bestimmte Datenmenge folgt, welche wiederum von der nächsten Synchronisationsinformation gefolgt wird.

Beispielsweise für Videodaten ist diese Art der Verarbeitung wichtig, da nur so die erforerliche Bildstruktur gewährleistet werden kann.

Ein derartiges Filter ist insbesondere dann sinnvoll einsetzbar, wenn der der Filteranordung zugeführte Datenstrom in einem Takt von einem anderen Signal übernommen wurde, dessen Takt nicht mit dem Übernahmetakt verkoppelt ist.

Gemäß einer Ausgestaltung der Erfindung nach Anspruch 2 ist eine Trennstufe vorgeehen, welche dafür sorgt, dass dem ersten Filter ausschließlich die Synchronisationsinformationen zugeführt werden.

Eine weitere Ausgestaltung der Erfindung nach Anspruch 3 betrifft den Fall, dass die Daten der Anordnung in einem externen Takt zugeführt werden, der nicht mit dem Systemtakt verkoppelt ist. Eine Akquisitionsstufe nimmt die Daten im Systemtakt entgegen und stellt fest, mit welchen Impulsen des Systemtaktes ein gültiges Datenbit der in dem externen nicht verkoppelten Takt vorliegenden Daten vorhanden ist. Immer wenn ein solches gültiges Datenbit auftritt, wird ein entsprechendes Akquisitionssignal an das zweite Filter geliefert. Damit wird sichergestellt, dass das zweite Filter nur dann ein neues Datum übernimmt, wenn dieses gültig ist und wenn es nicht, beispielsweise durch Doppelabtastung, tatsächlich dem vorherigen Datum entspricht.

Gemäß einer weiteren Ausgestaltung der Erfindung nach Anspruch 4 ist die Anzahl von Systemtaktimpulsen, während derer das erste Filter sperrt, so ausgelegt, dass die Filteranordnung nur so viele Daten übernimmt, wie nachgeschaltete Prozesse verarbeiten können. Ferner ist die vorgegebene Anzahl von Daten, die das zweite Filter nach Auftreten einer Synchronisationsinformation übernimmt, so ausgelegt, dass dann, wenn der externe Takt eine Solltaktfrequenz aufweist, alle Daten zwischen zwei aufeinanderfolgenden Synchronisationsinformationen durch die Filteranordnung übernommen werden. Damit wird im Normalfall, d.h. also wenn die externen Daten in der Sollfrequenz vorliegen, eine vollständige Datenübernahme gewährleistet.

Gemäß weiteren Ausgestaltungen der Erfindung nach den Ansprüchen 5, 6 und 7 kann die erfindungsgemäße Anordnung vorzugsweise zur Bearbeitung von Videodaten eingesetzt werden. In diesem Falle ist es vorteilhaft, dass das erste Filter als Synchronisationsinformationen die in den Videodaten enthaltenen Vertialsynchronisationsinformationen auswertet, so dass mittels des ersten Filters eine Ordnung nach Teilbildern stattfindet. Damit wird nach einem gestörten Datenfluß beginnend mit dem nächsten Teilbild wieder eine geordnete Übernahme von Videodaten erzielt. Das zweite Filter hingegen wertet zusätzlich zu den vom ersten Filter gelieferten Synchronisationsinformationen die in den Videodaten enthaltenen Horizontal- und Vertikalsynchronisationsimpulse aus. Damit wird erzielt, dass das zweite Filter zusätzlich eine Feinsortierung nach den Bildzeilen vornimmt.

Diese Eigenschaften der Filteranordnung bei der Verarbeitung von Videodaten können vorteilhaft, wie gemäß weiteren Ausgestaltungen der Erfindung nach den Ansprüchen 8 und 9 vorgesehen ist, zur weiteren nachfolgenden Kodierung der Videodaten eingesetzt werden. Für eine derartige Kodierung ist es insbesondere nach einem gestörten Videosignalfluß wichtig, dass die Daten möglichst schnell wieder nach den Synchronisationsinformationen geordnet vorliegen. Insbesondere ist es hierzu vorteilhaft, die Daten, die von dem zweiten Filter geliefert werden, zunächst in einem Speicher zwischenzuspeichern, aus dem der Enkodierungsprozeß die Daten dann entnimmt,

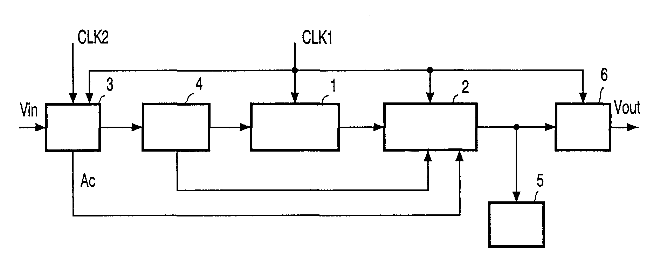

Nachfolgend wird anhand der einzigen Figur der Zeichnung ein Ausführungsbeispiel näher erläutert.

Die Figur zeigt in Form eines Blockschaltbildes eine erfindungsgemäße Anordnung, welche ein erstes Filter 1 und ein diesem nachgesschaltetes zweites Filter 2 aufweist. Beide Filter 1 und 2 werden mittels eines Systemtaktes CLK1 getaktet.

Das Eingangssignal der Schaltungsanordnung ist ein Videosignal Vin, welches in einem externen Takt CLK2 vorliegt, der nicht mit dem Systemtakt CLK1 verkoppelt ist. Die Videodaten Vin werden einer Akquisitionsstufe 3 zugeführt, welche ausgangsseitig die Videodaten in dem Systemtakt CLK1 liefert. Die Akquisitionsstufe nimmt also eine Neuabtastung der Daten vor, wobei die Akquisitionsstufe für jeden Systemtaktimpuls des Systemtaktes CLK1 feststellt, ob ein neues gültiges Datum der in dem externen Takt CLK2 vorliegenden Videodaten Vin vorliegt. Immer wenn dieses der Fall ist, wird in einem Akquisitionssignal Ac ein entsprechender Impuls an das zweite Filter 2 geliefert. Damit wird erreicht, dass das zweite Filter 2 nur gültige neue Daten übernimmt.

Der Akquisitionsstufe 3 ist eine Trennstufe 4 nachgeschaltet, welche den in dem Systemtakt vorliegenden Datenfluß, wie er von der Akquisitionsstufe 3 geliefert wird, einerseits in die Synchronisationsinformationen und andererseits in die reinen Daten trennt. Die Synchronisationsinformationen werden dem ersten Filter 1 eingangsseitig zugeführt. Die Daten werden dem zweiten Filter 2 zugeführt. In diesem Ausführungsbeipiel filtert die Trennstufe außer den vom ersten Filter 1 auszuwertenden Synchronisationsinformationen, nämlich den in den Video-Daten Vin enthaltenen Vertikal-Synchronisationsimpulsen, auch in den Video-Daten Vin enthaltene Horizontal-Synchronisationsimpulse aus, die das erste Filter 1 an das zweite Filter 2 weiterleitet.

Das zweite Filter 2 liefert ausgangsseitig die gefilterten Daten, welche einem Speicher 5 zugeführt werden, in welchem sie zwischengespeichert werden. Ein nachgeschaltetet Encodierungsprozeß 6, der beispielsweise die Daten in MPEG kodierte Daten umwandelt, welche dann das Ausgangssignal Vout darstellen, entnimmt die Daten aus dem Zwischenspeicher 5. Auf diesen Encodierungsprozeß 6, der auch im Systemtakt CLK1 arbeitet, soll im nachfolgenden nicht näher eingegangen werden, da er nicht Bestandteil der Erfindung ist.

Im nachfolgenden soll auf die Arbeitsweise des ersten Filters 1 und des zweiten Filters 2 näher eingegangen werden.

Dem ersten Filter 1 werden die mittels der Trennstufe 4 aus den digitalen Daten ausgefilterten Synchronisationsinformationen sowie Horizontal-Syvchronisationsimpulse zugeführt. Das erste Filter 1 wertet in dem Ausführungsbeispiel als Synchronisationsinformationen ausschließlich die Vertikal-Synchronisationsimpule aus. Tritt in den Videodaten ein solcher Vertikal-Synchronisationsimpuls auf, so übernimmt das erste Filter 1 diesen und schaltet ihn an seinen Ausgang durch. Alle nachfolgenden Synchronisationsinformationen werden während einer vorgegebenen Anzahl von Systemtaktimpulsen des Systemtaktes CLK1 gesperrt, d.h. nicht an den Ausgang des Filters 1 und damit an das Filter 2 weitergeleitet. Erst wenn die vorgegebene Anzahl von Systemtaktimpulsen abgelaufen ist, wird nachfolgend wieder der nächste auftretende Vertikal-Synchronisationsimpuls übernommen und an das zweite Filter 2 weitergeleitet.

Die vorgegebene Anzahl von Impulsen des Systemtaktes CLK1 ist so ausgelegt, dass der Encodierungsprozeß 6 Daten in dieser Anzahl von Takten vollständig verarbeiten kann.

Das zweite Filter 2 orientiert sich an den von dem ersten Filter 1 gelieferten Vertikal-Synchronisationsinformationen.

Wird von dem zweiten Filter 2 eine solche Synchronisationsinformation von dem ersten Filter übernommen, so übernimmt das zweite Filter 2 nachfolgend eine vorgegebene Anzahl von Daten von der Trennstufe 4 sowie Horizontal-Synchronistionsimpulse von Filter 1. Dabei orientiert sich das Filter 2 an dem Akquisitionssignal AC der Akquisitionsstufe 3 , so dass nur gültige Daten übernommen werden.

Das Filter 2 arbeitet dabei ebenfalls in einem zyklisch sich wiederholenden Vorgang, d.h. nach jeder gültigen Synchronisationsinformation, wie sie vom ersten Filter 1 geliefert wurde, wird die vorgegebene Anzahl von Daten übernommen. Nach dieser wird so lange gesperrt, bis wieder eine neue Synchronisationsinformation von dem ersten Filter 1 geliefert wird.

Damit wird sichergestellt, dass nach jeder Synchronisationsinformation eine vorgegebene Anzahl von Daten in dem Ausgangssignal des zweiten Filter 2 auftritt. Somit wird eine Ordnung der Daten erzielt, die somit in dieser geordneten Form in dem Zwischenspeicher 5 abgelegt werden können.

Darüber hinaus besteht die Möglichkeit, dass das zweite Filter nicht nur die vom ersten Filetr 1 gelieferten Synchronisationsinformationen (Vertikal-Synchronisationsimpulse) auswertet, sondern auch von dem ersten Filter 1 und/oder von der Trennstufe 4 gelieferte und in den Video-Daten enthaltene Horizontal-Synchronisationsimpulse. Somit kann das zweite Filter die Daten nicht nur nach Teilbildern, sondern auch nach Bildzeilen geordnet in dem Zwischenspeicher 5 ablegen.

Zu beachten ist also, dass das erste Filter die Synchronisationsinformationen ausfiltert und sich dabei an dem Systemtakt orientiert, dass aber das zweite Filter geordnet nach den Synchronisationsinformationen, wie sie vom ersten Filter geliefert werden, die Daten jeweils einer vorgegebenen Menge übernimmt. Das zweite Filter orientiert sich also dabei nicht an dem Systemtakt, sondern an der Datenmenge.

Die Anzahl von vorgegebenen Daten, die das zweite Filter 2 nach Auftreten einer Synchronisationsinformation übernimmt, ist orientiert an der Anzahl von Daten, die in einem Teilbild eines Videosignals auftreten. Im Ergebnis liefert die Anordnung die Daten ausgangsseitig auch nach einer Störung schnellstmöglich wieder in geordneter Form zur Abspeicherung in dem Speicher 5 und zur weiteren Verarbeitung durch den Enkodierungsprozeß. Damit wird nach einer Störung oder einem Ausfall von Daten eine möglichst schnelle Aufsynchronisation des Enkodierungsprozesses erreicht bzw. die gestörte Arbeitsweise des Enkodierungsprozesses 6, die bei gestörten Daten aufträte, wird schnellstmöglich wieder aufgehoben.

In der Praxis können derartige Probleme auftreten, wenn die eingangseitig auftretenden Videodaten beispielsweise von einem Videorekorder kommen, der in einer Sonderbetriebsart arbeitet. In dem Datenstrom treten dann Daten nicht mit der richtigen Zeitbasis oder auch gestört oder unvollständig auf. Dieser gestörte Datenfluß wird durch die erfindungsgemäße Filteranordnung wieder in eine Sollstruktur versetzt. Wird der Videorekorder aus dem Sonderbetriebsmodus wieder in den normalen Betriebsmodus versetzt, führt das erfindungsgemäße Filter dazu, dass die Daten wiederum in geordneter Weise und ohne Störstellen an den Enkodierungsprozeß 5 übergeben werden.

## Patentansprüche

1. Filter-Anordnung zur Filterung digitaler Daten, welche Synchronisationsinformationen enthalten, wobei die Anordnung in einem Systemtakt arbeitet,
dadurch gekennzeichnet,
dass die Anordnung ein erstes (1) und einem diesem nachgeschaltetes zweites Filter (2), das das Ausgangssignal der Anordnung liefert, aufweist,
dass dem ersten Filter (1) wenigstens die in den Daten enthaltenen Synchronisationsinformationen und dem zweiten Filter (2) das Ausgangssignal des ersten Filters (1) sowie die digitalen Daten zugeführt werden,
dass das erste Filter (1) in einem sich zyklisch wiederholenden Vorgang eine Synchronisationsinformation sucht, diese an seinen Ausgang durchschaltet, nachfolgend während einer vorgegebenen Anzahl von Systemtaktimpulsen alle ggf. auftretenden Synchronisationsinformationen sperrt und nach Ablauf der vorgegebenen Anzahl von Systemtakten wieder die nächste Synchronisationsinformation sucht und durchschaltet, und dass das zweite Filter (2) in einem sich zyklisch wiederholenden Vorgang ab einer von dem ersten Filter (1) gelieferten Synchronisationsinformation eine vorgegebene Anzahl von Daten aus dem Datensignal übernimmt und an seinen Ausgang durchschaltet und nachfolgende Daten bis zur nächsten von dem ersten Filter (1) gelieferten Synchronisationsinformation sperrt, ab der wieder die vorgegebene Anzahl von Daten dem Datensignal übernommen und an den Ausgang durchgeschaltet werden.

2. Anordnung nach Anspruch 1,
dadurch gekennzeichnet,
die Anordnung eine Trennstufe (4) aufweist, welche die dem ersten Filter (1) zugeführten Synchronisationsinformationen aus den digitalen Daten abtrennt.

3. Anordnung nach Anspruch 1,
dadurch gekennzeichnet,
dass die Daten einer in der Anordnung vorgesehenen Akquisitionsstufe (3) in einem externen Takt, der nicht mit dem Systemtakt verkoppelt ist, zugeführt werden, und dass die Akquisitionsstufe (3) feststellt, mit welchen Impulsen des Systemtakts ein gültiges neues Datenbit der seriellen Daten vorliegt, und welche ein entsprechendes Akquisitionssignal an das zweite Filter (2) liefert.

4. Anordnung nach Anspruch 1 und 3,
dadurch gekennzeichnet,
dass die vorgegebene Anzahl von Systemtaktimpulsen so ausgelegt ist, dass der Filter-Anordnung nachgeschaltete Prozesse die Datenrate des Ausgangssignals der Anordnung noch verarbeiten können und dass vorgegebene Anzahl von Daten so ausgelegt ist, dass dann, wenn der externe Takt eine Solltaktfrequenz aufweist, alle Daten zwischen zwei Synchronisationsinformationen übernommen werden.

5. Anordnung nach Anspruch 1,
dadurch gekennzeichnet,
dass es sich bei den Daten um Videodaten handelt, welche in Datenworten vorliegen.

6. Anordnung nach Anspruch 5,
dadurch gekennzeichnet,
dass das erste Filter (1) als Synchronisationsinformationen in den Videodaten enthaltene Vertikal-Synchronisationsimpulse auswertet.

7. Anordnung nach Anspruch 5,
dadurch gekennzeichnet,
dass das zweite Filter (2) als Synchronisationsinformationen die von dem ersten Filter gelieferten Vertikal-Synchronisationsimpulse auswertet und zusätzlich eine Ordnung der Daten in Abhängigkeit von Horzontal-Synchronisationsimpulsen vornimmt.

8. Anordnung nach Anspruch 1,
dadurch gekennzeichnet,
dass der Anordnung ein Speicher (5) nachgeschaltet ist, in welchen die Ausgangsdaten des zweiten Filters (2) nach Maßgabe der Synchronisationsinformation geordnet gespeichert werden.

9. Anordnung nach Anspruch 8,
dadurch gekennzeichnet,
dass der Anordnung ein MPEG-Enkodierungsprozeß (6) nachgeschaltet ist, welcher auf die in dem Speicher (5) gespeicherten Daten zugreift und dass das zweite Filter (2) ein den Füllstand der Daten in dem Speicher (5) angebendes Füllstandssignal an den ein MPEG-Enkodierungsprozeß (6) liefert.
